# EUROPEAN PATENT SPECIFICATION

(11) **EP 3 584 298 B1**
(45) Date of publication and mention of the grant of the patent: **28.12.2022**
(21) Application number: 18754174.3
(22) Date of filing: 29.01.2018
(51) Int. Cl.: C09K 3/14, C09G 1/02, H01L 21/02

(54) **POLISHING METHOD USING A POLISHING COMPOSITION**
POLIERVERFAHREN MIT VERWENDUNG EINER POLIERZUSAMMENSETZUNG
PROCÉDÉ DE POLISSAGE UTILISANT UNE COMPOSITION DE POLISSAGE

(30) Priority: 17.02.2017 JP 2017028303
(43) Date of publication of application: 25.12.2019
(73) Proprietor: Fujimi Incorporated, Kiyosu-shi, Aichi 452-8502 (JP)
(72) Inventor: MORI, Yoshio, Kiyosu-shi Aichi 452-8502 (JP); TANIGUCHI, Megumi, Kiyosu-shi Aichi 452-8502 (JP); MUKAI, Takatoshi, Kiyosu-shi Aichi 452-8502 (JP); TSUCHIYA, Kohsuke, Kiyosu-shi Aichi 452-8502 (JP)
(74) Representative: Grünecker Patent- und Rechtsanwälte PartG mbB
(86) International application number: PCT/JP2018/002697
(87) International publication number: WO 2018/150856

(56) References cited:
- WO-A1-2015/190065
- WO-A1-2016/158648
- WO-A1-2016/158648
- CN-A- 107 304 330
- JP-A- 2000 323 444
- JP-A- 2006 193 695
- US-A1- 2010 221 918

## Description

### TECHNICAL FIELD

The present invention relates to a polishing composition, a method for producing a polishing composition, and a polishing method using the polishing composition.

### BACKGROUND ART

Precision polishing using a polishing composition has been conventionally performed on a surface of a material such as metal, metalloid, non-metal, and oxides thereof. For example, a surface of a silicon wafer used as a component of a semiconductor product and the like is generally finished to a high quality mirror surface through a lapping step and a polishing step (fine polishing step). The polishing step typically includes a preliminary polishing step and a final polishing step.

For the purpose of identification or the like, a surface or a rear surface of a silicon wafer may be irradiated with laser light so as to provide the silicon wafer with a mark (hard laser mark) such as barcodes, numbers, and symbols. Such a hard laser mark is generally provided after completion of lapping step of a silicon wafer and before start of polishing step.

By the laser irradiation to provide a hard laser mark, a stressed layer is typically formed around a periphery of the hard laser mark. When preliminary polishing such as stock polishing is performed in the situation when the stressed layer is formed, bumps may generate around the periphery of the hard laser mark because the stressed layer is difficult to polish, to worsen flatness of the silicon wafer. For example, Patent Literature 1 discloses a polishing composition containing an abrasive, a weak acid salt, and a quaternary ammonium compound, and states that by the polishing composition, pH variation can be suppressed and polishing efficiency can be maintained so as to cancel a bump around a periphery of a hard laser mark. Patent Literature 2 discloses a processing composition for polishing chemical machinery, which is characterized by containing (A) a water-soluble amine, (B) a water-soluble polymer having a repeating unit including an aromatic hydrocarbon group, and an aqueous medium. Additionally, the processing composition contains (C) an organic acid having an aromatic hydrocarbon group, and has a pH not lower than 9. Patent Literature 3 discloses a chemical mechanical polishing aqueous dispersion, including (A) a sulfonic acid group-containing water-soluble polymer, (B) an amino acid, (C) abrasive grains, and (D) an oxidizing agent. Patent Literature 4 discloses a polishing composition containing silicon dioxide particles, at least one polymer compound selected from a group consisting of a polystyrene sulfonic acid, a polycarboxylic acid polymer, their salts and a polyvinyl acetate, and water. Patent Literature 5 discloses a polishing composition for silicon wafers containing silica particles having a BET average particle diameter of 50 nm or less, a weak acid salt and a quaternary ammonium compound.

### Citation List

### Patent Literature

Patent Literature 1: JP 2015-233031 A
Patent Literature 2: WO 2016/158648 A1
Patent Literature 3: US 2010/221918 A1
Patent Literature 4: JP 2006-193695 A
Patent Literature 5: WO 2015/190065 A1

### SUMMARY OF INVENTION

### Technical Problem

However, the stressed layer part is frequently stressed to polysilicon or the like by energy of laser light to increase its hardness. For this reason, in the polishing composition as described in Patent Literature 1, it is not sufficient yet to effectively cancel the bumps.

The present invention has been made in view of such circumstances, and an object thereof is to provide a polishing composition excellent in ability to cancel bump around a periphery of a hard laser mark.

Another object of the present invention is to provide a method for producing the polishing composition.

Still another object of the present invention is to provide a method for polishing an object to be polished which is provided with a hard laser mark by using the polishing composition.

### Means to Solve the Problems

The present inventors have found that the above-described problems can be solved by incorporating a water-soluble polymer containing a structural unit derived from styrene or a derivative thereof in a polishing composition, thereby completing the present invention.

That is, the present invention relates to the use of a polishing composition which includes an abrasive, a water-soluble polymer, a basic compound, and water, wherein the water-soluble polymer contains a structural unit derived from styrene or a derivative thereof, and is selected among polystyrene sulfonic acid or a salt thereof, polyvinyl benzoic acid or a salt thereof, a styrene-styrene sulfonic acid copolymer, a styrene-maleic acid copolymer, a styrene-maleic anhydride copolymer, a styrene sulfonic acid-maleic acid copolymer, a copolymer of styrene sulfonic acid salt and maleic acid, a styrene-(meth)acrylic acid copolymer, a styrene sulfonic acid-(meth)acrylic acid copolymer, a copolymer of a styrene sulfonic acid salt and (meth)acrylic acid, and wherein the abrasive is selected among silica particles, alumina particles, ceria particles, titania particles, silicon nitride particles, and polymethyl methacrylate (PMMA) particles, and wherein the basic compound is selected from the list consisting of carbonates, hydroxide of alkali metal, quaternary ammonium hydroxide or salts thereof, ammonia, methylamine, dimethylamine, trimethylamine, ethylamine, diethylamine, triethylamine, ethylenediamine, monoethanolamine, N-(□-aminoethyl) ethanolamine, hexamethylenediamine, diethylenetriamine, triethylenetetramine, anhydrous piperazine, piperazine hexahydrate, 1-(2-aminoethyl)piperazine, N-methylpiperazine, guanidine, imidazole and triazole, and wherein the polishing composition is used for polishing a silicon wafer provided with a hard laser mark.

Further, the present invention also relates to a method for polishing a silicon wafer which is provided with a hard laser mark by using a polishing composition.

### Effects of the Invention

According to the present invention, a polishing composition excellent in performance to cancel a bump around a periphery of a hard laser mark can be provided.

Further, according to the present invention, a method for polishing an object to be polished provided with a hard laser mark by using the polishing composition can be provided.

### DESCRIPTION OF EMBODIMENTS

A polishing composition for the use of the present invention contains an abrasive, a water-soluble polymer, a basic compound, and water, and the water-soluble polymer contains a structural unit derived from styrene or a derivative thereof.

According to a polishing composition for the use of the present invention, a bump(s) around a periphery(ies) of a hard laser mark(s) can be effectively cancelled. Incidentally, in the present specification, cancellation of a bump(s) around a periphery(ies) of a hard laser mark(s) indicates reducing a height of a bump around a periphery of a hard laser mark of a silicon wafer. A height of a bump around a periphery of a hard laser mark of a silicon wafer can be measured, for example, by the method described in Examples described later.

A mechanism by which such an effect is obtainable is considered as follows. However, the following mechanism is only based on estimation and is not intended to limit the scope of the present invention.

Since irradiation treatment with laser light is performed in order to provide a silicon wafer with a hard laser mark, a stressed layer is frequently formed in a single crystal silicon portion around a periphery of the hard laser mark and to increase hardness. For this reason, when a silicon wafer is polished using a conventional polishing composition, it is difficult to etch or mechanically polish with an abrasive an stressed part around a periphery of a hard laser mark as compared to wafer parts other than the stressed part, and to decrease a polishing removal rate. As a result, a bump around the periphery of the hard laser mark remains not to be cancelled. On the other hand, when a silicon wafer is polished using the polishing composition of the present invention, problems as mentioned above can be overcome. A specific reason would be as follows. When the water-soluble polymer containing a structural unit derived from styrene or a derivative thereof as described in the present invention is added, the water-soluble polymer suitably acts on a surface of a silicon wafer other than bump portion, so that an etching speed or a mechanical polishing removal rate by an abrasive of a silicon wafer can be suppressed as compared to the absence of the water-soluble polymer. According to this, it is considered that a difference in polishing removal rates between stressed parts and other wafer parts can be reduced.

Therefore, by polishing using a polishing composition for the use of the present invention, a stressed part(s) around a periphery(ies) of a hard laser mark(s) can be polished at a similar polishing removal rate to a part(s) other than the stressed part(s), so that a partial bump(s) can be cancelled.

Hereinafter, embodiments of the present invention will be described. Incidentally, the present invention is not limited only to the following embodiments.

In the present specification, unless otherwise specified, operations, measurement of physical properties, and the like are performed under conditions at room temperature (20 to 25°C)/relative humidity of 40 to 50 %RH.

A polishing composition for the use of the present invention comprises an abrasive, a water-soluble polymer, a basic compound, and water, and the water-soluble polymer contains a structural unit derived from styrene or a derivative thereof. Hereinafter, each configuration of the polishing composition of the present invention will be described.

### <Abrasive>

A polishing composition for the use of the present invention contains an abrasive(s). The abrasive contained in a polishing composition serve to mechanically polish an object to be polished.

The abrasive used herein may be any of inorganic particles, organic particles, and organic-inorganic composite particles. Specific examples of the inorganic particles include particles composed of a metal oxide such as silica, alumina, ceria, and titania, silicon nitride particles, silicon carbide particles, and boron nitride particles. Specific examples of the organic particles include polymethyl methacrylate (PMMA) particles. The abrasive may be used singly or as a mixture of two or more kinds. Further, the abrasive used may be a commercially available product or a synthetic product.

Among these abrasive, silica is preferable and colloidal silica is particularly preferable.

The lower limit of an average primary particle diameter of the abrasive is preferably 10 nm or more, more preferably 15 nm or more, further preferably 20 nm or more, and particularly preferably 30 nm or more. In addition, the upper limit of the average primary particle diameter of the abrasive is preferably 200 nm or less, more preferably 150 nm or less, and further preferably 100 nm or less. Within such a range, a polishing removal rate of an object to be polished by the polishing composition can be further improved and occurrence of defects on a surface of an object to be polished after being polished using the polishing composition can be further suppressed. Incidentally, the average primary particle diameter of the abrasive is calculated, for example, on the basis of a specific surface area of the abrasive measured by BET method.

The lower limit of the average secondary particle diameter of the abrasive is preferably 15 nm or more, more preferably 30 nm or more, further preferably 50 nm or more, and particularly preferably 70 nm or more. Further, the upper limit of the average secondary particle diameter of the abrasive is preferably 300 nm or less, more preferably 260 nm or less, and further preferably 220 nm or less. Within such a range, a polishing removal rate of an object to be polished by the polishing composition can be further improved and occurrence of defects on a surface of an object to be polished after being polished using the polishing composition can be further suppressed. The average secondary particle diameter of secondary particles can be measured, for example, by a dynamic light scattering method.

A content of the abrasive in a polishing composition for the use according to the present invention is not particularly limited. As described later, in the case of a polishing composition used for polishing an object to be polished as a polishing liquid without any changes (which is typically a slurry polishing liquid and also called as a working slurry or a polishing slurry), the content of the abrasive is preferably 0.01% by mass or more, more preferably 0.1% by mass or more, and further preferably 0.5% by mass or more, with respect to the polishing composition. With an increase in the content of the abrasive, higher bump-cancellation ability tend to be obtainable. Further, from the viewpoint of scratch prevention and the like, the content of the abrasive is usually suitably 10% by mass or less, preferably 5% by mass or less, more preferably 3% by mass or less, and particularly preferably 1% by mass or less. Decreasing of the content of the abrasive is also preferable from the viewpoint of economic efficiency. The polishing composition according to the present invention can exhibit practically sufficient bump-cancellation ability even in the case of such a low content of the abrasive.

Further, in the case of a polishing composition diluted prior to use in polishing (that is, concentrated liquid), a content of the abrasive is, from the viewpoint of storage stability, filterability, and the like, usually suitably 30% by mass or less, and more preferably 15% by mass or less. Further, from the viewpoint of taking advantages of using the polishing composition as a concentrated liquid, the content of the abrasive is preferably 1% by mass or more and more preferably 5% by mass or more.

### <Water>

A polishing composition for the use according to the present invention contains water as a dispersion medium for dispersing or dissolving each component. Water preferably contains impurities as little as possible from the viewpoint of the inhibition of contamination of an object to be cleaned and action of impurities on other components. As such water, for example, water of a total content of transition metal ions of 100 ppb or less is preferable. Herein, purity of water can be increased, for example, by operations such as removal of impurity ions using an ion exchange resin, removal of contaminants by a filter, and distillation, and the like. Specifically, as water, for example, deionized water (ion-exchanged water), pure water, ultrapure water, distilled water, or the like is preferably used.

The dispersion medium may be a mixed solvent of water and an organic solvent in order to disperse or dissolve each component. In this case, examples of an organic solvent used include acetone, acetonitrile, ethanol, methanol, isopropanol, glycerin, ethylene glycol, propylene glycol, and the like that are an organic solvent miscible with water. Further, these organic solvents may be used without being mixed with water to disperse or dissolve each component, and then mixed with water. These organic solvents can be used singly or in combination of two or more kinds.

### <Water-Soluble Polymer>

A polishing composition for the use according to the present invention contains a water-soluble polymer, and the water-soluble polymer contains a structural unit derived from styrene or a derivative thereof. Since the water-soluble polymer which can be used in the present invention contains a structural unit derived from styrene or a derivative thereof, it is considered that the water-soluble polymer suitably acts on a surface of a silicon wafer. According to this, it is considered that a polishing removal rate of the silicon wafer is decreased, a difference in polishing removal rates between the silicon wafer and an stressed part around a periphery of hard laser mark is reduced, and thus a bump can be cancelled.

The water-soluble polymer which can be used in the present invention may be a polymer containing only a structural unit derived from styrene or a derivative thereof or a copolymer containing a structural unit derived from styrene or a derivative thereof and a structural unit derived from another monomer. In particular, when the copolymer containing a structural unit derived from styrene or a derivative thereof and a structural unit derived from another monomer is used, more favorable bump-cancellation ability can be obtained, which is preferable.

Examples of the water-soluble polymer containing only a structural unit derived from styrene or a derivative thereof include polystyrene sulfonic acid or a salt thereof, polyvinyl benzoic acid or a salt thereof, a styrene-styrene sulfonic acid copolymer, and the like.

In the case of using the water-soluble polymer of a copolymer containing a structural unit derived from styrene or a derivative thereof and a structural unit derived from another monomer, for example, a copolymer which contain a structural unit derived from styrene or a derivative thereof and a structural unit derived from a monomer having a carboxy group or an acid anhydride group as a hydrophilic group may be used. Specific examples thereof include a styrene-maleic acid copolymer, a styrene-maleic anhydride copolymer, a styrene sulfonic acid-maleic acid copolymer, a copolymer of a styrene sulfonic acid salt and maleic acid copolymer, a styrene-(meth)acrylic acid copolymer, a styrene sulfonic acid-(meth)acrylic acid copolymer, a copolymer of a styrene sulfonic acid salt and (meth)acrylic acid, and the like. From the viewpoint of bump-cancellation ability, a styrene-maleic acid copolymer or a styrene-maleic anhydride copolymer can be preferably used, and a styrene-maleic anhydride copolymer can be further preferably used. Since the water-soluble polymer of the copolymer has a hydrophobic group and a hydrophilic group independently, the water-soluble polymer easily acts on a silicon wafer, which is suitable. It can be produced, for example, by radical copolymerization of styrene or a derivative thereof and another monomer. In the case of using the copolymer, the copolymerization ratio of the structural unit derived from styrene or a derivative thereof and the structural unit derived from another monomer in the copolymer is not particularly limited, and from the viewpoint of hydrophilicity, it is preferably 1 : 10 or more, further preferably 1 : 5 or more, and particularly preferably 1 : 1 or more. Further, the copolymerization ratio is not particularly limited, and from the viewpoint of bump-cancellation ability, it is preferably 10 : 1 or less, further preferably 5 : 1 or less, and particularly preferably 3 : 1 or less.

A weight average molecular weight of the water-soluble polymer which can be used in the present invention is not particularly limited, and is preferably 3,000 or more, further preferably 4,000 or more, and particularly preferably 5,000 or more. Further, the weight average molecular weight of the water-soluble polymer is not particularly limited, and is preferably 300,000 or less, further preferably 100,000 or less, and particularly preferably 30,000 or less. As the weight average molecular weight of the water-soluble polymer increases, it is considered that coverage thereof to a silicon wafer increases and thus bump-cancellation ability can be improved. As the weight average molecular weight of the water-soluble polymer decreases, the number of water-soluble polymer chains which can act on a wafer is increased so that a denser protective layer can be formed. Incidentally, in the present specification, as the weight average molecular weight, a value measured by GPC method (aqueous, based on standard polyethylene oxide) can be employed.

In the case of a polishing composition used as it is for polishing an object to be polished as a polishing liquid, a content of the water-soluble polymer is preferably 0.0001% by mass or more and more preferably 0.001% by mass or more, with respect to the polishing composition. With an increase in the content of the water-soluble polymer, higher bump-cancellation ability would tend to be obtainable. Further, the content of the water-soluble polymer is usually suitably 0.1% by mass or less, and more preferably 0.05% by mass or less. As the content of the water-soluble polymer in the polishing composition decreases, a decrease in polishing removal rate would be suppressed.

Further, in the case of a polishing composition (that is, a concentrated liquid) used for polishing after dilution, a content of the water-soluble polymer is, from the viewpoint of storage stability, filterability, and the like, usually suitably 1% by mass or less, and more preferably 0.5% by mass or less. Further, from the viewpoint of taking advantage of using the polishing composition as a concentrated liquid, the content of the water-soluble polymer is preferably 0.001% by mass or more and more preferably 0.01% by mass or more.

In the present invention, the water-soluble polymer may be synthesized by a known method or a commercially available product may be used.

### <Basic Compound>

A polishing composition for the use according to the present invention contains a basic compound. Herein, the basic compound refers to a compound having a function to increase pH of a polishing composition upon addition thereto. The basic compound may function to chemically polish a surface to be polished and contribute to improve a polishing removal rate. Further, the basic compound may help increase dispersion stability of the polishing composition.

As the basic compound, organic or inorganic nitrogen-containing basic compounds, hydroxides of alkali metals or alkaline earth metals, various carbonates and hydrogen carbonates, and the like can be used. Examples thereof include hydroxides of alkali metals, quaternary ammonium hydroxides or salts thereof, ammonia, amines, and the like. Specific examples of the hydroxides of alkali metals include potassium hydroxide, sodium hydroxide, and the like. Specific examples of the carbonates or hydrogen carbonates include ammonium hydrogen carbonate, ammonium carbonate, potassium hydrogen carbonate, potassium carbonate, sodium hydrogen carbonate, sodium carbonate, and the like. Specific examples of the quaternary ammonium hydroxides or salts thereof include tetramethylammonium hydroxide, tetraethylammonium hydroxide, tetrabutylammonium hydroxide, and the like. Specific examples of the amines include methylamine, dimethylamine, trimethylamine, ethylamine, diethylamine, triethylamine, ethylenediamine, monoethanolamine, N-(β-aminoethyl)ethanolamine, hexamethylenediamine, diethylenetriamine, triethylenetetramine, anhydrous piperazine, piperazine hexahydrate, 1-(2-aminoethyl)piperazine, N-methylpiperazine, guanidine, azoles such as imidazole and triazole, and the like.

Examples of the basic compound preferable from the viewpoint of improving a polishing removal rate, and the like include ammonia, potassium hydroxide, sodium hydroxide, tetramethylammonium hydroxide, tetraethylammonium hydroxide, ammonium hydrogen carbonate, ammonium carbonate, potassium hydrogen carbonate, potassium carbonate, sodium hydrogen carbonate, and sodium carbonate. Among others, preferable examples thereof include ammonia, potassium hydroxide, sodium hydroxide, tetramethylammonium hydroxide, and tetraethylammonium hydroxide. More preferable examples thereof include potassium carbonate and tetramethylammonium hydroxide. Such basic compounds can be used singly or in combination of two or more kinds. When the basic compounds are used in combination of two or more kinds, a combination of potassium carbonate and tetramethylammonium hydroxide is preferable, for example.

In the case of a polishing composition used as it is for polishing an object to be polished as a polishing liquid, a content of the basic compound is, from the viewpoint of accelerating a polishing removal rate, preferably 0.01% by mass or more, more preferably 0.05% by mass or more, and further preferably 0.09% by mass or more, with respect to the polishing composition. With an increase the content of the basic compound, stability can also be improved. The upper limit of the content of the basic compound is suitably 1% by mass or less, and from the viewpoint of surface quality and the like, is preferably 0.5% by weight or less. Further, in the case of using two or more kinds of the basic compound in combination, the content indicates a total content of two or more kinds of the basic compound.

Further, in the case of a polishing composition (that is, a concentrated liquid) used for polishing after dilution, a content of the basic compound is, from the viewpoint of storage stability, filterability, and the like, usually suitably 10% by mass or less, and more preferably 5% by mass or less. Further, from the viewpoint of taking advantage of using the polishing composition as a concentrated liquid, the content of the basic compound is preferably 0.1% by mass or more, more preferably 0.5% by mass or more, and further preferably 0.9% by mass or more.

### <Other Components>

A polishing composition for the use according to the present invention may further contain, if necessary, known additives usable in polishing compositions (typically, polishing compositions used for a polishing step of a silicon wafer) such as a chelating agent, a surfactant, an antiseptic agent, and an antifungal agent, as long as the effects of the present invention are not significantly impaired.

Examples of the chelating agent, which may be contained in the polishing composition if necessary, include aminocarboxylic acid-based chelating agents and organophosphonic acid-based chelating agents. Examples of the aminocarboxylic acid-based chelating agents include ethylenediamine tetraacetic acid, ethylenediamine tetraacetic acid sodium salt, nitrilotriacetic acid, nitrilotriacetic acid sodium salt, nitrilotriacetic acid ammonium, hydroxyethylethylenedimaine triacetic acid, hydroxyethylethylenediamine triacetic acid sodium salt, diethylenetriamine pentaacetic acid, diethylenetriamine pentaacetic acid sodium salt, triethylenetetramine hexaacetic acid, and triethylenetetramine hexaacetic acid sodium salt. Examples of the organophosphonic acid-based chelating agents include 2-aminoethylphosphonic acid, 1-hydroxyethylidene-1,1-diphosphonic acid, aminotri(methylenephosphonic acid), ethylenediaminetetrakis(methylenephosphonic acid), diethylenetriaminepenta(methylenephosphonic acid), ethane-1,1-diphosphonic acid, ethane-1,1,2-triphosphonic acid, ethane-1-hydroxy-1,1-diphosphonic acid, ethane-1-hydroxy-1,1,2-triphosphonic acid, ethane-1,2-dicarboxy-1,2-diphosphonic acid, methanehydroxyphosphonic acid, 2-phosphonobutane-1,2-dicarboxylic acid, 1-phosphonobutane-2,3,4-tricarboxylic acid, and α-methylphosphonosuccinic acid. Among them, organophosphonic acid-based chelating agents are more preferable. Among them, preferable examples thereof include ethylenediaminetetrakis(methylenephosphonic acid), diethylenetriaminepenta(methylenephosphonic acid), and diethylenetriamine pentaacetic acid. Particularly preferable examples of chelating agents include ethylenediaminetetrakis(methylenephosphonic acid) and diethylenetriaminepenta(methylenephosphonic acid). The chelating agents can be used singly or in combination of two or more kinds.

In the case of a polishing composition used as it is for polishing an object to be polished as a polishing liquid, a content of the chelating agent is preferably 0.0001% by mass or more, more preferably 0.001% by mass or more, and further preferably 0.005% by mass or more, with respect to the polishing composition. The upper limit of the content of the chelating agent is preferably 1% by mass or less, more preferably 0.5% by mass or less, further preferably 0.3% by mass or less, and particularly preferably 0.15% by mass or less.

Further, in the case of a polishing composition (that is, a concentrated liquid) used for polishing after dilution, a content of the chelating agent is, from the viewpoint of storage stability, filterability, and the like, usually suitably 5% by mass or less, more preferably 3% by mass or less, and particularly preferably 1.5% by mass or less. Further, from the viewpoint of taking advantage of using the polishing composition as a concentrated liquid, the content of the chelating agent is preferably 0.001% by mass or more, more preferably 0.01% by mass or more, and further preferably 0.05% by mass or more.

Examples of the antiseptic agent and the antifungal agent, which may be contained in the polishing composition if necessary, include isothiazolin-based antiseptic agents such as 2-methyl-4-isothiazolin-3-one and 5-chloro-2-methyl-4-isothiazolin-3-one, p-hydroxybenzoate esters, phenoxyethanol, and the like. These antiseptic agent and antifungal agent may be used singly or in combination of two or more kinds.

### <Polishing Composition>

A polishing composition for the use according to the present invention is typically supplied in a form of a polishing liquid containing the polishing composition to an object to be polished, and is used for polishing the object to be polished. The polishing composition according to the present invention may be diluted (typically with water) to be used as a polishing liquid, or may be used as it is as a polishing liquid. In other words, the concept of the polishing composition in the technique pertain to the present invention encompasses both a polishing composition (working slurry) supplied to an object to be polished and used for polishing the object to be polished and a concentrated liquid (stock solution of working slurry) which is used in polishing after dilution. A concentration rate of the concentrated liquid can be set, for example, to about 2 times to 100 times by volume and is usually suitably about 5 times to 50 times.

In the case of a polishing composition used as it is for polishing an object to be polished as a polishing liquid, pH of the polishing composition is typically 9.0 or more, preferably 9.5 or more, more preferably 10.0 or more, and further preferably 10.2 or more, and is, for example, 10.5 or more. When the pH of the polishing liquid increases, bump-cancellation ability would tend to be improved. Meanwhile, from the viewpoint of preventing the abrasive from dissolution and suppressing degradation of mechanical polishing action with the abrasive, the pH of the polishing liquid is suitably 12.0 or less, preferably 11.8 or less, and further preferably 11.5 or less.

Further, in the case of a polishing composition (that is, a concentrated liquid) used for polishing after dilution, pH of the polishing composition is typically 9.5 or more, preferably 10.0 or more, and more preferably 10.2 or more. Further, the pH of the polishing composition is suitably 12.0 or less and preferably 11.5 or less.

Incidentally, the pH of a polishing composition can be found as follows: a pH meter (for example, glass electrode-type hydrogen ion concentration indicator (model: F-23) manufactured by HORIBA, Ltd.) and used, and standard buffer solutions (a phthalate pH buffer solution with a pH of 4.01 (25°C), a neutral phosphate pH buffer solution with a pH of 6.86 (25°C), and a carbonate pH buffer solution with a pH of 10.01 (25°C)) are used to perform three-point calibration. Then, a glass electrode is immersed in the polishing composition, and after 2 minutes or longer, a stabilized value is measured.

### <Polishing Method>

A polishing composition for the use according to the present invention can be used for polishing an object to be polished, for example, in a manner including the following operations.

That is, a working slurry including a polishing composition for the use according to the present invention is provided. Then, a polishing composition is supplied to an object to be polished to polish the object to be polished in usual way. For example, an object to be polished is set to a general polishing machine and the polishing composition is supplied to a surface (surface to be polished) of the object to be polished through a polishing pad of the polishing machine. Typically, while the polishing composition is continuously supplied, the polishing pad is pressed against the surface of the object to be polished, and the polishing pad and the object to be polished are relatively moved (for example, rotationally moved). Through such polishing steps, the polishing of the object to be polished is completed.

The polishing pad used in the polishing step is not particularly limited. For example, any of expanded polyurethane type, nonwoven fabric type, suede type, type including an abrasive, type including no abrasive, and the like may be used. Further, as the polishing machine, a double-side polishing machine which polishes both surfaces of an object to be polished at the same time may be used, or a single-side polishing machine which polishes only one surface of an object to be polished may be used.

The polishing composition may be used in a manner in which the polishing composition once used for polishing is discarded (so-called "one-way"), or may be repeatedly used in recycle. One example of the method for using the polishing composition in recycle includes collecting the polishing composition after use that is discarded from the polishing machine into a tank, and supplying the collected polishing composition to the polishing machine again. In the case of using the polishing composition in recycle, an amount of the polishing composition after use that is treated as wasted liquid can be reduced as compared with the case of one-way, and thus, environmental stress can be reduced. Further, when an amount of the used polishing composition is reduced, the cost can be suppressed.

### <Application>

A polishing composition for the use according to the present invention is excellent in performance to cancel a bump(s) around periphery(ies) of a hard laser mark(s) (bump-cancellation ability). Taking such advantage, the polishing composition can be preferably applied to polishing of an object to be polished including a surface provided with a hard laser mark. That is, in an embodiment of the present invention, there is provided a method for polishing an object to be polished which is provided with a hard laser mark by using the polishing composition according to the present invention. Further, examples of the object to be polished include substrates having an inorganic insulation film, such as a silicon oxide film or a silicon nitride film, formed, substrates having a polycrystalline silicon film formed, silicon single crystal substrates (silicon wafers), and the like. Among these, the object to be polished is preferably a silicon wafer. That is, the polishing composition according to the present invention is suitable as a polishing composition used for polishing a silicon wafer provided with a hard laser mark. Further, the polishing composition according to the present invention is suitable as a polishing composition used in a step of polishing a silicon wafer provided with a hard laser mark. It is desirable to cancel a bump(s) around periphery(ies) of a hard laser mark(s) at the initial polishing step. Therefore, the polishing composition according to the present invention may be particularly preferably used in a first polishing step (primary polishing step) after provision of hard laser mark(s). The first polishing step is typically performed as a double-side polishing step of polishing both surfaces of a silicon wafer at the same time. The polishing composition according to the present invention may be preferably used in such a double-side polishing step.

Therefore, the present invention also provides a method for improving flatness of a silicon wafer provided with a hard laser mark, by using a polishing composition containing an abrasive, a water-soluble polymer, a basic compound, and water. The water-soluble polymer contains a structural unit derived from styrene or a derivative thereof.

The polishing composition according to the present invention can be used also for polishing a surface to be polished having no hard laser marks. For example, regardless of presence or absence of hard laser marks, the polishing composition can be preferably applied to preliminary polishing of a silicon wafer which has been subjected to lapping.

### Examples

The invention will be described in more detail by means of the following Examples and Comparative Examples. However, the technical scope of the present invention is not limited only to the following Examples. Incidentally, unless otherwise specified, "%" and "part(s)" each mean "% by mass" and "part(s) by mass." Further, in the following Examples, unless otherwise specified, operations were performed under conditions of room temperature (25°C)/relative humidity of 40 to 50 %RH.

### <Preparation of Polishing Composition>

### (Polishing Composition A1)

The following components and ion-exchanged water were stirred and mixed at room temperature of about 25°C for about 30 minutes such that a content of colloidal silica (average primary particle diameter : 55 nm) is 9% by mass, a content of potassium carbonate (K₂CO₃) is 1.7% by mass, a content of tetramethylammonium hydroxide (TMAH) is 2.5% by mass, a content of ethylenediaminetetrakis(methylenephosphonic acid) (EDTPO) is 0.1% by mass, and a content of styrene-maleic anhydride copolymer (weight average molecular weight: 9,500, styrene/maleic anhydride (S/M) = 3/1) is 0.01% by mass, thereby preparing a polishing composition A1.

### (Polishing Compositions A2 to A4 and Polishing Compositions C1 to C4)

Polishing compositions A2 to A4 and polishing compositions C1 to C4 were prepared by a similar method to that of the polishing composition A1, except that the type or content of the water-soluble polymer was changed as described in Table 1.

Further, water-soluble polymers used in each polishing composition are as follows:
- Styrene-maleic anhydride copolymer (Mw = 9,500 S/M = 3/1)
- Styrene-maleic anhydride copolymer (Mw = 9,500 S/M = 3/1)
- Styrene-maleic anhydride copolymer (Mw = 5,500 S/M = 1/1)
- Sodium polystyrene sulfonate (Mw = 20,000)
- Polymethyl vinyl ether-maleic anhydride copolymer (Mw = 200,000 Me/M = 1/1)
- Hydroxyethyl cellulose (Mw = 250,000)
- Polyvinyl alcohol (Mw = 10,000)

### <Polishing of Silicon Wafer>

Each polishing composition was diluted 10 times with water, the diluent was used as a polishing liquid (working slurry), to polish a surface of an object to be polished (test pieces) under the following conditions to obtain Examples 1 to 4 and Comparative Examples 1 to 4. As the test piece, a commercially available silicon etched wafer having a diameter of 4 inch (100 mm) and having been subjected to lapping (Bare Si P-<100>, thickness: 545 **µ**m) was used. In this wafer, the polished surface was engraved with hard laser marks based on SEMI M1(T7) standard.

### (Polishing Conditions)

Polishing machine: Single-side polishing machine, model "EJ-380IN" manufactured by Engis Japan Corporation
Polishing pressure: 12.0 kPa
Slurry flow rate: 100 ml/min
Platen rotational speed : 50 rpm
Number of rotations of head: 40 rpm
Polishing removal: 3.5 µm
Polishing pad: Product name "MH-S15A" manufactured by Nitta Haas Incorporated
Temperature of polishing environment: 20°C
Polishing time: 20 minutes

### <Evaluation of Bump-cancellation Ability>

Regarding the silicon wafer after being polished, a height of bump was measured using SURFCOM 1500DX (manufactured by TOKYO SEIMITSU CO., LTD.) to evaluate bump-cancellation ability. Specifically, a height of bump was checked by running a needle directly along the periphery of the silicon wafer, and a difference in level between a part with bump and a part without bumps (= bump height) was calculated. An increased bump height indicates poorer bump-cancellation ability. The results obtained by the above measurement are presented in Table 1.

**[Table 1]**

| | Polishing liquid | Type of water-soluble polymer | Content of water-soluble polymer in polishing liquid (wt%) | Bump height (µm) |
|---|---|---|---|---|
| Example 1 | A1 | Styrene-maleic anhydride copolymer (Mw = 9, 500 S/M = 3/1) | 0.001 | 0.94 |
| Example 2 | A2 | Styrene-maleic anhydride copolymer (Mw = 9, 500 S/M = 3/1) | 0.002 | 0.85 |
| Example 3 | A3 | Styrene-maleic anhydride copolymer (Mw = 5,500 S/M = 1/1) | 0.001 | 0.93 |
| Example 4 | A4 | Sodium polystyrene sulfonate (Mw = 20,000) | 0.001 | 1.17 |
| Comparative Example 1 | C1 | None | - | 1.90 |
| Comparative Example 2 | C2 | Polymethyl vinyl ether-maleic anhydride copolymer(Mw = 200,000 Me/M = 1/1) | 0.001 | 1.95 |
| Comparative Example 3 | C3 | Hydroxyethyl cellulose(Mw = 250,000) | 0.003 | 2.13 |
| Comparative Example 4 | C4 | Polyvinyl alcohol(Mw = 10,000) | 0.001 | 2.05 |

It is noted from Table 1 that according to the polishing composition of the present invention in Examples 1 to 4, in all cases, favorable bump-cancellation ability was exhibited. Among the polishing compositions containing a water-soluble polymer having a structural unit derived from styrene or a derivative thereof, according to Examples using a styrene-maleic anhydride copolymer, higher bump-cancellation ability was obtainable.

On the other hand, Comparative Example 1 having added with no water-soluble polymer having a structural unit derived from styrene or a derivative thereof was inferior to Examples in bump-cancellation ability. Further, in Comparative Examples 2 to 4, although another water-soluble polymer was added instead of the water-soluble polymer having a structural unit derived from styrene or a derivative thereof, bump-cancellation ability were inferior, as compared to Examples. The reason for this is considered that, in the case of a copolymer having no structural units derived from styrene, a polishing removal rate of silicon wafer is higher than a polishing removal rate of a stressed part around periphery of hard laser mark, and a different between heights of both parts is increased as compared to that of the polishing compositions of Examples.

Although specific examples of the present invention have been described in detail hereinbefore, but they are merely illustrative examples, and are not intended to limit the scope of claims. The techniques described in claims include various modifications and changes of the above-exemplified specific examples.

## Claims

1. The use of a polishing composition for polishing a silicon wafer, wherein the polishing composition comprises an abrasive, a water-soluble polymer, a basic compound, and water, wherein the water-soluble polymer contains a structural unit derived from styrene or a derivative thereof,
and is selected amonq polystyrene sulfonic acid or a salt thereof, polyvinyl benzoic acid or a salt thereof, a styrene-styrene sulfonic acid copolymer, a styrene-maleic acid copolymer, a styrene-maleic anhydride copolymer, a styrene sulfonic acid-maleic acid copolymer, a copolymer of styrene sulfonic acid salt and maleic acid, a styrene- (meth)acrylic acid copolymer, a styrene sulfonic acid-(meth)acrylic acid copolymer, a copolymer of a styrene sulfonic acid salt and (meth)acrylic acid,
and wherein the abrasive is selected among silica particles, alumina particles, ceria particles, titania particles, silicon nitride particles, and polymethyl methacrylate (PMMA) particles,
and wherein the basic compound is selected from the list consisting of carbonates, hydroxide of alkali metal, quaternary ammonium hydroxide or salts thereof, ammonia, methylamine, dimethylamine, trimethylamine, ethylamine, diethylamine, triethylamine, ethylenediamine, monoethanolamine, N-(β-aminoethyl) ethanolamine, hexamethylenediamine, diethylenetriamine, triethylenetetramine, anhydrous piperazine, piperazine hexahydrate, 1-(2-aminoethyl)piperazine, N-methylpiperazine, guanidine, imidazole and triazole,
and wherein the polishing composition is used for polishing a silicon wafer provided with a hard laser mark.

2. The use of a polishing composition according to claim 1, wherein the water-soluble polymer is a salt of polystyrene sulfonic acid, a styrene-maleic anhydride copolymer or a styrene-maleic acid copolymer.

3. The use of a polishing composition according to claim 2, wherein the water-soluble polymer is a styrene-maleic anhydride copolymer or a styrene-maleic acid copolymer, and a copolymerization ratio of a structural unit derived from styrene and a structural unit derived from maleic anhydride or maleic acid in the copolymer is 1 : 1 or more and 3 : 1 or less.

4. A method for polishing a silicon wafer, wherein the silicon wafer is provided with a hard laser mark by using a polishing composition,
wherein the polishing composition comprises an abrasive, a water-soluble polymer, a basic compound, and water, wherein the water-soluble polymer contains a structural unit derived from styrene or a derivative thereof,
and is selected among polystyrene sulfonic acid or a salt thereof, polyvinyl benzoic acid or a salt thereof, a styrene-styrene sulfonic acid copolymer, a styrene-maleic acid copolymer, a styrene-maleic anhydride copolymer, a styrene sulfonic acid-maleic acid copolymer, a copolymer of styrene sulfonic acid salt and maleic acid, a styrene- (meth)acrylic acid copolymer, a styrene sulfonic acid-(meth)acrylic acid copolymer, a copolymer of a styrene sulfonic acid salt and (meth)acrylic acid,
and wherein the abrasive is selected among silica particles, alumina particles, ceria particles, titania particles, silicon nitride particles, and polymethyl methacrylate (PMMA) particles,
and wherein the basic compound is selected from the list consisting of carbonates, hydroxide of alkali metal, quaternary ammonium hydroxide or salts thereof, ammonia, methylamine, dimethylamine, trimethylamine, ethylamine, diethylamine, triethylamine, ethylenediamine, monoethanolamine, N-(β-aminoethyl) ethanolamine, hexamethylenediamine, diethylenetriamine, triethylenetetramine, anhydrous piperazine, piperazine hexahydrate, 1-(2-aminoethyl)piperazine, N-methylpiperazine, guanidine, imidazole and triazole.

## Patentansprüche

1. Verwendung einer Polierzusammensetzung zum Polieren eines Siliziumwafers, wobei die Polierzusammensetzung ein Schleifmittel, ein wasserlösliches Polymer, eine basische Verbindung und Wasser umfasst, wobei das wasserlösliche Polymer eine Struktureinheit enthält, die von Styrol oder einem Derivat davon herrührt,
und ausgewählt ist aus Polystyrolsulfonsäure oder einem Salz davon, Polyvinylbenzoesäure oder einem Salz davon, einem Styrol-Styrolsulfonsäure-Copolymer, einem Styrol-Maleinsäure-Copolymer, einem Styrol-Maleinsäureanhydrid-Copolymer, einem Styrolsulfonsäure-Maleinsäure-Copolymer, Styrol-Maleinsäure-Copolymer, Styrolsulfonsäure-Maleinsäure-Copolymer, Styrolsulfonsäure-Maleinsäure-Copolymer, Styrolsulfonsäure-Maleinsäure-Copolymer, Styrolsulfonsäure-Maleinsäure-Copolymer, Styrolsulfonsäuresalz-Maleinsäure-Copolymer,
und wobei das Schleifmittel ausgewählt ist aus Siliziumdioxidteilchen, Aluminiumoxidteilchen, Ceroxidteilchen, Titandioxidteilchen, Siliziumnitridteilchen und Polymethylmethacrylatteilchen (PMMA),
und wobei die basische Verbindung ausgewählt ist aus der Liste bestehend aus Carbonaten, Alkalimetallhydroxiden, quaternärem Ammoniumhydroxid oder Salzen davon, Ammoniak, Methylamin, Dimethylamin, Trimethylamin, Ethylamin, Diethylamin, Triethylamin, Ethylendiamin, Monoethanolamin, N-(β-Aminoethyl)ethanolamin, Hexamethylendiamin, Diethylentriamin, Triethylentetramin, wasserfreiem Piperazin, Piperazinhexahydrat, 1-(2-Aminoethyl)piperazin, N-Methylpiperazin, Guanidin, Imidazol und Triazol,
und wobei die Polierzusammensetzung zum Polieren eines mit einer harten Lasermarkierung versehenen Siliziumwafers verwendet wird.

2. Die Verwendung einer Polierzusammensetzung nach Anspruch 1, wobei das wasserlösliche Polymer ein Salz einer Polystyrolsulfonsäure , eines Styrol-Maleinsäureanhydrid-Copolymers oder eines Styrol-Maleinsäure-Copolymers ist.

3. Die Verwendung einer Polierzusammensetzung nach Anspruch 2, wobei das wasserlösliche Polymer ein Styrol-Maleinsäureanhydrid-Copolymer oder ein Styrol-Maleinsäure-Copolymer ist und ein Copolymerisationsverhältnis einer Struktureinheit, die von Styrol herrührt, und einer Struktureinheit, die von Maleinsäureanhydrid oder Maleinsäure herrührt, in dem Copolymer 1 : 1 oder mehr und 3 : 1 oder weniger ist.

4. Verfahren zum Polieren eines Siliziumwafers, bei dem der Siliziumwafer unter Verwenden einer Polierzusammensetzung mit einer harten Lasermarkierung versehen wird,
wobei die Polierzusammensetzung ein Schleifmittel, ein wasserlösliches Polymer, eine basische Verbindung und Wasser umfasst, wobei das wasserlösliche Polymer eine Struktureinheit enthält, die von Styrol oder einem Derivat davon herrührt,
und ausgewählt ist aus Polystyrolsulfonsäure oder einem Salz davon, Polyvinylbenzoesäure oder einem Salz davon, einem Styrol-Styrolsulfonsäure-Copolymer, einem Styrol-Maleinsäure-Copolymer, einem Styrol-Maleinsäureanhydrid-Copolymer, einem Styrolsulfonsäure-Maleinsäure-Copolymer, Styrol-Maleinsäure-Copolymer, Styrolsulfonsäure-Maleinsäure-Copolymer, Styrolsulfonsäure-Maleinsäure-Copolymer, Styrolsulfonsäure-Maleinsäure-Copolymer, Styrolsulfonsäure-Maleinsäure-Copolymer, Styrolsulfonsäuresalz-Maleinsäure-Copolymer,
und wobei das Schleifmittel ausgewählt ist aus Siliziumdioxidteilchen, Aluminiumoxidteilchen, Ceroxidteilchen, Titandioxidteilchen, Siliziumnitridteilchen und Polymethylmethacrylatteilchen (PMMA),
und wobei die basische Verbindung ausgewählt ist aus der Liste bestehend aus Carbonaten, Alkalimetallhydroxiden, quaternärem Ammoniumhydroxid oder Salzen davon, Ammoniak, Methylamin, Dimethylamin, Trimethylamin, Ethylamin, Diethylamin, Triethylamin, Ethylendiamin, Monoethanolamin, N-(β-Aminoethyl)ethanolamin, Hexamethylendiamin, Diethylentriamin, Triethylentetramin, wasserfreiem Piperazin, Piperazinhexahydrat, 1-(2-Aminoethyl)piperazin, N-Methylpiperazin, Guanidin, Imidazol und Triazol.

## Revendications

1. Utilisation d'une composition de polissage pour polir une tranche de silicium, la composition de polissage comprenant un abrasif, un polymère hydrosoluble, un composé basique et de l'eau,
le polymère hydrosoluble contenant un motif structural dérivé du styrène ou d'un dérivé de celui-ci, et étant choisi parmi le poly(acide styrènesulfonique) ou un sel de celui-ci, le poly(acide vinylbenzoïque) ou un sel de celui-ci, un copolymère de styrène et d'acide styrènesulfonique, un copolymère de styrène et d'acide maléique, un copolymère de styrène et d'anhydride maléique, un copolymère d'acide styrènesulfonique et d'acide maléique, un copolymère d'un sel d'acide styrènesulfonique et d'acide maléique, un copolymère de styrène et d'acide (méth)acrylique, un copolymère d'acide styrènesulfonique et d'acide (méth)acrylique, un copolymère d'un sel d'acide styrènesulfonique et d'acide (méth)acrylique,
et l'abrasif étant choisi parmi des particules de silice, des particules d'alumine, des particules d'oxyde de cérium, des particules d'oxyde de titane, des particules de nitrure de silicium et des particules de poly(méthacrylate de méthyle) (PMMA),
et le composé basique étant choisi dans la liste constituée par des carbonates, un hydroxyde de métal alcalin, un hydroxyde d'ammonium quaternaire ou des sels de ceux-ci, l'ammoniaque, la méthylamine, la diméthylamine, la triméthy-lamine, l'éthylamine, la diéthylamine, la triéthylamine, l'éthylènediamine, la monoé-thanolamine, la N-(*β*-aminoéthyl)éthanolamine, l'hexaméthylènediamine, la diéthy-lènetriamine, la triéthylènetétramine, la pipérazine anhydre, la pipérazine hexahydrate, la 1-(2-aminoéthyl)pipérazine, la N-méthylpipérazine, la guanidine, l'imidazole et le triazole,
et la composition de polissage étant utilisée pour polir une tranche de silicium pourvue d'un repère laser dur.

2. Utilisation d'une composition de polissage selon la revendication 1, le polymère hydrosoluble étant un sel de poly(acide styrènesulfonique), un copolymère de styrène et d'anhydride maléique ou un copolymère de styrène et d'acide maléique.

3. Utilisation d'une composition de polissage selon la revendication 2, le polymère hydrosoluble étant un copolymère de styrène et d'anhydride maléique ou un copolymère de styrène et d'acide maléique, et un rapport de copolymérisation d'un motif structural dérivé du styrène et d'un motif structural dérivé de l'anhydride maléique ou de l'acide maléique dans le copolymère étant de 1:1 ou plus, et 3:1 ou moins.

4. Procédé de polissage d'une tranche de silicium, la tranche de silicium étant pourvue d'un repère laser dur, au moyen d'une composition de polissage,
la composition de polissage comprenant un abrasif, un polymère hydrosoluble, un composé basique et de l'eau,
le polymère hydrosoluble contenant un motif structural dérivé du styrène ou d'un dérivé de celui-ci, et étant choisi parmi le poly(acide styrènesulfonique) ou un sel de celui-ci, le poly(acide vinylbenzoïque) ou un sel de celui-ci, un copolymère de styrène et d'acide styrènesulfonique, un copolymère de styrène et d'acide maléique, un copolymère de styrène et d'anhydride maléique, un copolymère d'acide styrènesulfonique et d'acide maléique, un copolymère d'un sel d'acide styrènesulfonique et d'acide maléique, un copolymère de styrène et d'acide (méth)acrylique, un copolymère d'acide styrènesulfonique et d'acide (méth)acrylique, un copolymère d'un sel d'acide styrènesulfonique et d'acide (méth)acrylique,
et l'abrasif étant choisi parmi des particules de silice, des particules d'alumine, des particules d'oxyde de cérium, des particules d'oxyde de titane, des particules de nitrure de silicium et des particules de poly(méthacrylate de méthyle) (PMMA),
et le composé basique étant choisi dans la liste constituée par des carbonates, un hydroxyde de métal alcalin, un hydroxyde d'ammonium quaternaire ou des sels de ceux-ci, l'ammoniaque, la méthylamine, la diméthylamine, la triméthy-lamine, l'éthylamine, la diéthylamine, la triéthylamine, l'éthylènediamine, la monoé-thanolamine, la N-(*β*-aminoéthyl)éthanolamine, l'hexaméthylènediamine, la diéthy-lènetriamine, la triéthylènetétramine, la pipérazine anhydre, la pipérazine hexahydrate, la 1-(2-aminoéthyl)pipérazine, la N-méthylpipérazine, la guanidine, l'imidazole et le triazole.
